(19) Europäisches Patentamt
European Patent Office
Office européen des brevets

(11) **EP 1 519 025 B1**

(12) **EUROPÄISCHE PATENTSCHRIFT**

(45) Veröffentlichungstag und Bekanntmachung des Hinweises auf die Patenterteilung:
**15.05.2013  Patentblatt 2013/20**

(51) Int Cl.:
*F02D 41/20* *(2006.01)*      *F02D 41/22* *(2006.01)*
*H01L 41/04* *(2006.01)*      *H03K 17/08* *(2006.01)*
*H03K 17/14* *(2006.01)*

(21) Anmeldenummer: 04018896.3

(22) Anmeldetag: **10.08.2004**

(54) **Verfahren und Vorrichtung zum Betreiben einer Brennkraftmaschine**

Method and device for operating a combustion engine

Méthode et appareil d'exploitation d'un moteur à combustion

(84) Benannte Vertragsstaaten:
**DE FR GB IT**

(30) Priorität: **23.09.2003  DE 10344005**
**13.03.2004  DE 102004012428**

(43) Veröffentlichungstag der Anmeldung:
**30.03.2005  Patentblatt 2005/13**

(73) Patentinhaber: **ROBERT BOSCH GMBH**
**70442 Stuttgart (DE)**

(72) Erfinder:
• **Huber, Andreas**
**71711 Steinheim (DE)**

• **Reineke, Joerg**
**71254 Ditzingen (DE)**
• **Sutter, Kai**
**70372 Stuttgart (DE)**
• **Gangi, Marco**
**73734 Esslingen (DE)**
• **Wiedmann, Martin**
**73333 Gingen (DE)**
• **Schinzel, Mirko**
**70378 Stuttgart (DE)**

(56) Entgegenhaltungen:
**EP-A1- 1 139 444      DE-A1- 10 210 163**
**DE-A1- 10 240 493      DE-A1- 19 860 762**
**GB-A- 2 364 793**

EP 1 519 025 B1

**Beschreibung**

Stand der Technik

Die Erfindung betrifft ein Verfahren zum Betreiben einer Brennkraftmaschine mit $n_{zyl}$ Zylindern, welche von einem Steuergerät über vorzugsweise jeweils einen zugeordneten Aktor individuell angesteuert werden. Neben dem Verfahren betrifft die Erfindung ein Computerprogramm und eine Vorrichtung zur Durchführung dieses Verfahrens sowie einen Datenträger mit einem derartigen Computerprogramm.

Im Stand der Technik ist zum Beispiel aus der EP 1 139 444 A1 ein Einspritzsystem für eine Brennkraftmaschine sowie ein Verfahren zur Steuerung derselben bekannt. Das Einspritzsystem umfasst Piezo-Aktoren zum Steuern der in die Zylinder der Brennkraftmaschine jeweils eingespritzten Kraftstoffmenge. Darüber hinaus umfasst das Einspritzsystem einen Ansteuerschaltkreis zum Ansteuern der Piezo-Aktoren, wobei zwischen den Ansteuerschaltkreis und die Piezo-Aktoren ein Pufferkondensator geschaltet ist. Die besagte bekannte Anmeldung schlägt vor, den Spannungsabfall über dem Pufferkondensator und/oder die Ladung des Pufferkondensators zu überwachen, um für den Fall, dass ein Abfall dieser Pufferspannung unterhalb eines vorgegebenen Schwellenwertes festgestellt wird, auf einen Fehler, insbesondere bei den Piezo-Aktoren, rückschließen zu können.

Das Steuergerät und insbesondere der darin enthaltene DC-DC-Wandler ist so ausgebildet, dass er sekundärseitig, wenn möglich, jede von den Aktoren geforderte Leistung bereitstellt. Dies erfolgt traditionell in der Weise, dass, wenn ein Abfall der Spannung über dem Pufferkondensator zum Beispiel aufgrund einer verstärkten Leistungsaufnahme durch die Aktoren festgestellt wird, die von dem DC/DC-Wandler bereitgestellte Leistung erhöht wird; gegebenenfalls auch über die nominelle Abgabeleistung des Wandlers hinaus. Ein derart verstärkter Leistungsverbrauch durch die Aktoren kann zum einen durch Bauteiltoleranzen oder durch Alterungseffekte bei den Aktoren bedingt sein. Die bisher durchgeführte unkontrollierte Anhebung der von dem Wandler bereitgestellten Leistung kann jedoch dazu führen, dass sich der Wandler aufgrund der dabei entstehenden Verlustleistung zu stark erwärmt und zerstört wird. Diese Gefahr besteht insbesondere dann, wenn einer oder mehrere Injektoren der Brennkraftmaschine bezüglich ihres Energieverbrauchs ihren Spezifikationsbereich verlassen.

Ausgehend von diesem Stand der Technik ist es deshalb die Aufgabe der Erfindung, ein Verfahren, ein Computerprogramm und eine Vorrichtung zum Betreiben einer Brennkraftmaschine bereitzustellen, welche eine thermische Zerstörung des DC-DC-Wandlers aufgrund eines erhöhten Energieverbrauchs von mindestens einem Aktor vermeidet.

Diese Aufgabe wird durch das im Patentanspruch 1 beanspruchte Verfahren gelöst. Dieses Verfahren ist dadurch gekennzeichnet, dass die von vorzugsweise allen Aktoren der Brennkraftmaschine insgesamt verbrauchte mittlere elektrische Leistung erfasst wird, dass diese erfasste mittlere elektrische Leistung mit einer vorgegebenen nominalen Sollleistung des Steuergerätes verglichen wird und dass die von den Aktoren zukünftig insgesamt verbrauchte elektrische Leistung reduziert wird, wenn der Vergleich zeigt, dass die erfasste mittlere elektrische Leistung größer als die vorgegebene Sollleistung ist, welche die von dem Steuergerät an die Aktoren abgebbare Nennleistung repräsentiert.

Im Sinne der Erfindung bedeutet "aufgenommene Leistung" die von einem Aktor während eines Ladevorganges aufgenommene Leistung. Weiterhin bedeutet der Begriff "abgegebene Leistung" die von einem Aktor während eines Entladevorgangs freigesetzte elektrische Leistung. Und schließlich bedeutet der Begriff "verbrauchte elektrische Leistung beziehungsweise Energie" die Differenz zwischen aufgenommener und abgegebener elektrischer Leistung beziehungsweise Energie. Für die Erfindung wesentlich ist grundsätzlich die verbrauchte elektrische Leistung beziehungsweise die verbrauchte elektrische Energie, weil diese zumindest im Mittel die von dem Steuergerät 120 beziehungsweise die von der Wandlereinrichtung 122 bereitzustellende elektrische Leistung repräsentiert.

Vorteile der Erfindung

Dieses beanspruchte Verfahren bietet den Vorteil, dass eine thermische Zerstörung des Steuergerätes beziehungsweise des darin befindlichen DC/DC-Wandlers aufgrund der vorgeschlagenen Regelung der von diesem bereitzustellenden elektrischen Leistung vermieden wird. Damit wird automatisch auch vermieden, dass ein PKW, bei dem dieses Verfahren implementiert ist, aufgrund eines Ausfalls dieses Wandlers im Feld liegen bleibt und dass anschließend ein Austausch des Steuergerätes vorgenommen werden muss.

Vorteilhafterweise geht der Erfassung der von vorzugsweise allen Aktoren aufgenommenen mittleren elektrischen Leistung eine zylinderspezifische Erfassung des Energieverbrauchs der einzelnen Aktoren der Brennkraftmaschine voraus. Zur Berechnung dieser Energieverbräuche werden die von jedem einzelnen Aktor während eines Ladevorganges für eine Einspritzung aufgenommene Energie und die von dem Aktor während eines nachfolgenden Entladevorganges abgegebene Energie ermittelt; daraus resultiert ein gemessener Energieverbrauch pro Aktor. Für die Berechnung der mittleren verbrauchten elektrischen Leistung aller Aktoren der Brennkraftmaschine aus den gemessenen Energieverbräuchen der einzelnen Aktoren werden zwei Ausführungsbeispiele beschrieben, wobei die Berechnung gemäß dem ersten Ausführungsbeispiel in Abhängigkeit des jeweils aktuellen Arbeitspunktes der Brennkraftmaschine und die Berechnung gemäß dem zweiten Ausführungsbeispiel vorteilhafterweise unabhängig von dem aktuellen Arbeitspunkt erfolgt.

Vorteilhafterweise erfolgt eine Fehlerstatusmeldung, wenn die von dem Aktor aufgenommene oder abgegebene Energie, dessen Energieverbrauch oder ein Abweichungsfaktor jeweils zugeordnete Schwellenwerte unter- oder überschreitet. Eine derartige Fehlermeldung kann vorteilhafterweise bei einem späteren Werkstattbesuch ausgelesen und dann zur Fehlerdiagnose verwendet werden.

Vorteilhafterweise wird die von den Aktoren aufgenommene Leistung dadurch reduziert, dass, bei zumindest einzelnen Einspritzzyklen, normalerweise vorgesehene Nebeneinspritzungen weggelassen werden. Damit wird, wie erwünscht, der Leistungsbedarf oder alternativ der Energieverbrauch pro Einspritzzyklus reduziert, ohne dass dies für den Fahrer mit merklichen Einschränkungen verbunden wäre. Eine mögliche Einschränkung könnte zum Beispiel darin bestehen, dass der Fahrer ein erhöhtes Verbrennungsgeräusch bemerkt. Im Gegensatz zu anderen möglichen Maßnahmen zur Reduzierung der Leistungsaufnahme, wie zum Beispiel der Begrenzung der Motordrehzahl, der Abschaltung eines Aktors beziehungsweise eines Zylinders oder der Reduzierung einer Aktorspannung mit dem Ergebnis, dass der Aktor nicht mehr wirkungsvoll arbeiten würde, sind die Auswirkungen für den Fahrer bei der bevorzugten Ausführungsform jedoch am geringsten.

Die oben genannte Aufgabe wird weiterhin durch ein Computerprogramm, durch einen Datenträger mit diesem Computerprogramm sowie durch eine Vorrichtung zum Durchführen dieses Verfahrens gelöst. Die Vorteile dieser Lösungen entsprechen den oben mit Bezug auf das Verfahren genannten Vorteilen.

Weitere vorteilhafte Ausgestaltungen des Verfahrens und der Vorrichtung sind Gegenstand der abhängigen Ansprüche.

Zeichnungen

Der Beschreibung sind fünf Figuren beigefügt, wobei

Figur 1    eine erfindungsgemäße Vorrichtung zum Betreiben einer Brennkraftmaschine;

Figur 2    einen Verfahrensablauf zum Betreiben der Brennkraftmaschine;

Figur 3    ein erstes Ausführungsbeispiel für den detaillierten Aufbau einer Regeleinrichtung;

Figur 4    einen typischen Spannungsverlauf beim Laden und Entladen eines Piezo-Aktors; und

Figur 5    ein zweites Ausführungsbeispiel für den detaillierten Aufbau der Regelungseinrichtung

zeigt.

Beschreibung der Ausführungsbeispiele

Die Erfindung wird nachfolgend detailliert in Form von Ausführungsbeispielen unter Bezugnahme auf die genannten Figuren beschrieben.

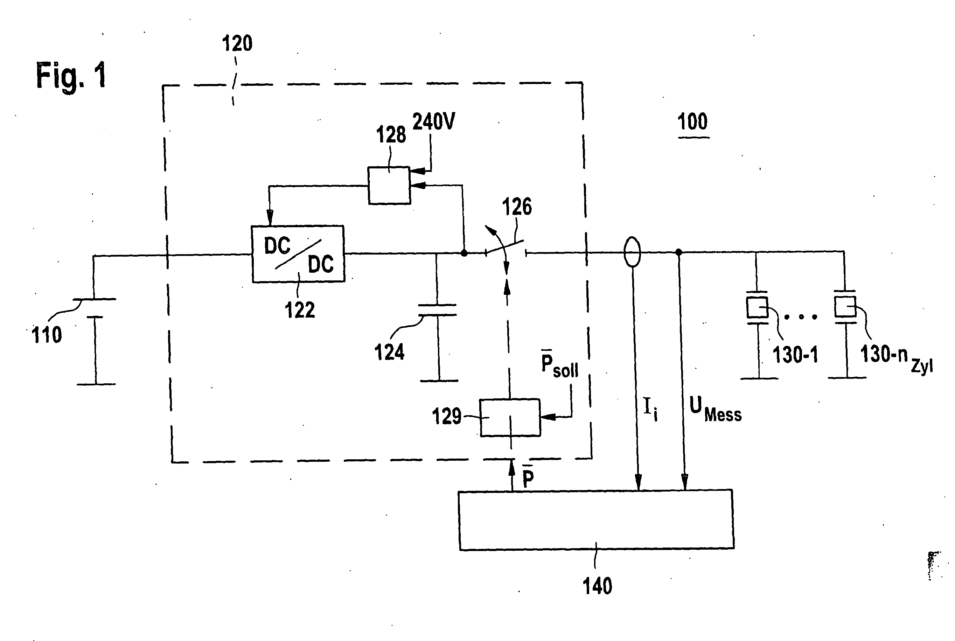

Figur 1 zeigt den Aufbau einer erfindungsgemäßen Vorrichtung 100 zum Betreiben einer Brennkraftmaschine (nicht gezeigt) mit $n_{zyl}$ Zylindern. Die Vorrichtung 100 wird von einer Spannungsquelle 110, in der Regel die Bordbatterie eines Kraftfahrzeugs, betrieben. Die Vorrichtung 100 umfasst ein Steuergerät 120 zum individuellen Ansteuern von insbesondere Piezo-Aktoren 130-1 ...130-$n_{zyl}$ zum Einspritzen von Kraftstoff in die den Aktoren zugeordneten Zylinder. Für die Beschreibung der Erfindung wird beispielhaft davon ausgegangen, dass jedem Zylinder jeweils ein Aktor zugeordnet ist, so dass die Anzahl der Aktoren $n_{zyl}$ gleich der Anzahl der Zylinder $n_{zyl}$ ist.

Das Steuergerät 120 umfasst in seinem Inneren einen DC/DC-Wandler 122 zum Hochtransformieren der Batteriespannung auf einen erforderlichen Wert von vorzugsweise 240 V. Diese Ausgangsspannung des DC/DC-Wandlers 122 wird in einem Pufferkondensator 124 gepuffert und zur Ansteuerung der Aktoren 130-1...130-$n_{zyl}$ bereitgestellt. Diese Spannungsversorgung innerhalb des Steuergerätes 120 ist so ausgebildet, dass sie, sofern irgendwie möglich, jede von den Aktoren nachgefragte elektrische Leistung für diese bereitstellt. Falls erforderlich, stellt diese Spannungsversorgungseinrichtung, zumindest kurzfristig, auch eine elektrische Leistung in einer Größenordnung bereit, die oberhalb ihrer eigenen nominellen Abgabeleistung liegt.

Die Leistungs- beziehungsweise Spannungsregelung innerhalb des Steuergerätes 120 funktioniert wie folgt:

Wenn die Aktoren 130-1...130-$n_{zyl}$ einen erhöhten Leistungsbedarf haben und deshalb eine erhöhte Leistung von dem Steuergerät bereitgestellt wird, so zeigt sich dies in einem Spannungsabfall über dem Pufferkondensator 124.

Dieser Spannungsabfall wird von einer Vergleichereinrichtung 128 erfasst und mit einer vorgegebenen Referenzspannung, typischerweise 240 V, verglichen. Wenn die Vergleichereinrichtung'128 einen Einbruch der Spannung über dem Pufferkondensator gegenüber der Referenzspannung feststellt, so veranlasst sie den DC/DC-Wandler 122 über ein von ihr ausgegebenes Steuersignal die von ihm an seinem Ausgang beziehungsweise an dem Pufferkondensator 124 bereitgestellte elektrische Leistung so weit wie erforderlich zu erhöhen.

Aufgrund von Bauteiltoleranzen beziehungsweise aufgrund von Alterungseffekten bei den Aktoren 130-1, 130-$n_{zyl}$ kann der Leistungsbedarf der Aktoren auch über die nominelle Abgabeleistung des DC/DC-Wandlers 120 ansteigen. Es kommt dann zu einer starken Wärmeentwicklung in dem Wandler 122 und es besteht die Gefahr, dass dieser aufgrund der Verlustleistung beziehungsweise der daraus resultierenden Erwärmung zerstört wird. Diese Gefahr besteht insbesondere dann, wenn einer oder mehrere Aktoren 130...130-$n_{zyl}$ bezüglich ihres Energieverbrauchs ihren Spezifikationsbereich verlassen.

Um eine derartige thermische Zerstörung des DC/DC-Wandlers 122 aufgrund einer Drift des Energieverbrauchs der Piezo-Aktoren gegenüber ihrem nominellen Energieverbrauch zu vermeiden, wird erfindungsgemäß eine Regeleinrichtung 140 vorgesehen, zur Überwachung und Regelung der von den Aktoren verbrauchten beziehungsweise aufgenommenen und von dem Steuergerät 120 bereitgestellten elektrischen Leistung.

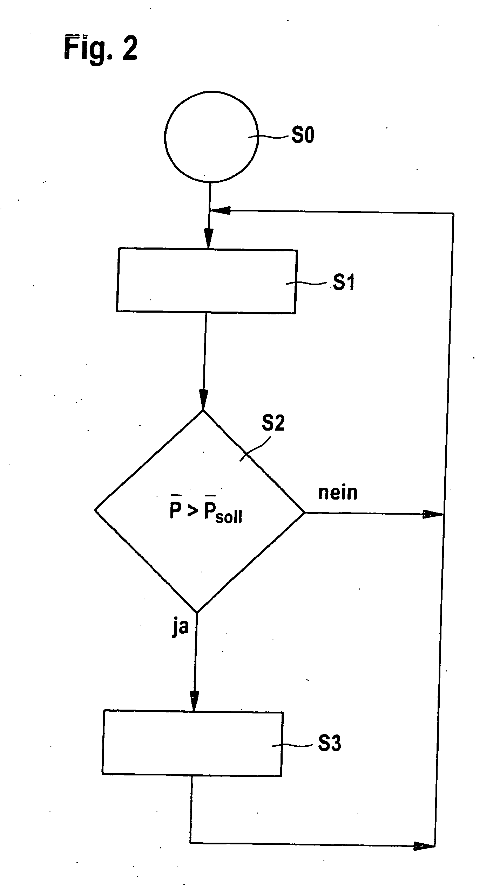

Figur 2 zeigt das grundsätzliche Funktionsprinzip der erfindungsgemäßen Regelungseinrichtung 140. Nach einem Startschritt S0 erfolgt in Verfahrensschritt S1 eine Erfassung der von vorzugsweise allen Aktoren 130-1...130-$n_{zyl}$ der Brennkraftmaschine aufgenommenen mittleren elektrischen Leistung $\overline{P}$. In einem nachfolgenden Verfahrensschritt S2 wird diese erfasste mittlere elektrische Leistung mit einer vorgegebenen mittleren Soll-Leistung $\overline{P}_{soll}$ des Steuergerätes 120 und insbesondere des Wandlers 122 verglichen. Solange die erfasste mittlere elektrische Leistung die Soll-Leistung nicht übersteigt, wird keine Gegenmaßnahme eingeleitet und stattdessen die Überwachung in Form eines wiederholten Erfassens und Vergleichens der erfassten mittleren elektrischen Leistung fortgesetzt. Wenn jedoch in Verfahrensschritt S2 festgestellt wird, dass die mittlere erfasste elektrische Leistung, das heißt die von den Aktoren aufgenommene elektrische Leistung größer als die vorgegebene Soll-Leistung $\overline{P}_{soll}$ ist, welche die von dem Steuergerät bereitstellbare Nennleistung repräsentiert, dann wird in

verfahrensschritt S3 eine Reduzierung der von den Aktoren zukünftig insgesamt verbrauchten elektrischen Leistung durch die Regelungseinrichtung 140 im Zusammenwirken mit dem Steuergerät 120 veranlasst.

Nach der Reduktion der durch die Aktoren verbrauchten elektrischen Leistung verzweigt das erfindungsgemäße Verfahren wieder auf den Beginn von Verfahrensschritt S1.

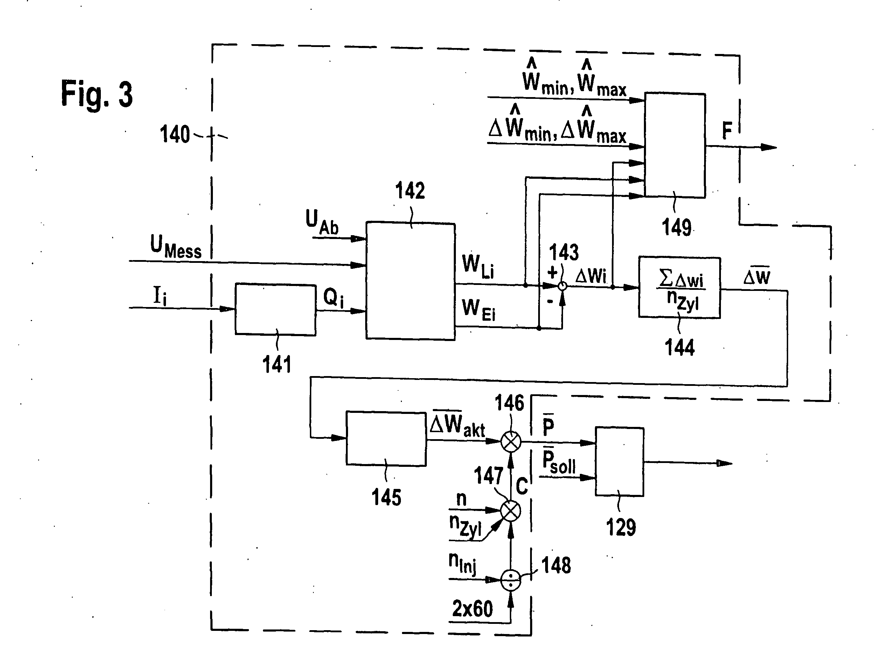

Figur 3 zeigt ein erstes Ausführungsbeispiel für den genauen Aufbau und die genaue Funktionsweise der erfindungsgemäßen Regelungseinrichtung 140. Es ist zu erkennen, dass sie als Eingangsgrößen die den parallel geschalteten Aktoren 130-1...130-$n_{zyl}$ zugeführte Spannung $U_{Mess}$ sowie den zylinderspezifisch i fließenden Strom $I_i$ empfängt. Diese beiden Messgrößen werden vorzugsweise am Ausgang des Steuergerätes 120 abgegriffen, bevor sie den Aktoren 130-1...130-$n_{zyl}$ zugeführt werden. Alternativ dazu können diese beiden Messgrößen auch dadurch ermittelt werden, dass Spannungs- und Stromgrößen innerhalb des Steuergerätes 120 ermittelt und unter Berücksichtigung etwaiger Verluste mit Hilfe der Knoten- und Maschenregel für elektrische Stromkreise auf die Größen $U_{Mess}$ und $I_i$ umgerechnet werden. Innerhalb der Regelungseinrichtung 140 wird der gemessene Strom $I_i$ zunächst mit Hilfe einer Ladungsmesseinrichtung 141 in eine entsprechende Ladung Qi umgewandelt. Beide Größen, sowohl die Spannung $U_{Mess}$ wie auch die berechnete Ladung $Q_i$ werden einer Energiemesseinrichtung 142 zugeführt, welche aus diesen beiden Größen die während eines Ladevorganges für einen Einspritzvorgang von einem Aktor aufgenommene Energie $W_{Li}$ sowie die während eines nachfolgenden Entladevorganges von demselben Aktor abgegebene Energie $W_{Ei}$ berechnet. Die Energiemesseinrichtung 142 berechnet die Ladeenergie $W_{Li}$ gemäß folgender Formel (1):

$$W_{Li} = \int_0^{t\_laden} u(t) \cdot i(t)\, dt , \qquad (1)$$

wobei:

t_laden      die Ladezeit
u(t)      die gemessene elektrische Spannung über einem Aktor; und

i(t)      den gemessenen Aktorstrom

repräsentiert.

Analog berechnet die Energiemesseinrichtung 142 die Entladeenergie $W_{Ei}$ gemäß folgender Gleichung (2):

$$W_{Ei} \;=\; \int_{0}^{t\_entladen} u(t) \cdot i(t)\, dt , \tag{2}$$

wobei

t_entladen      die Entladezeit

repräsentiert.

Wenn es nicht möglich ist, den Stromverlauf $Hu_2$ kontinuierlich zu messen, so empfiehlt sich die Benutzung der folgenden Näherungen:

$$W\_z \;=\; \Delta U\_z \cdot \int_{0}^{t\_z} i(t)\,(dt) \cdot f\_Corr\_z , \tag{3}$$

$$W\_z \;=\; \Delta U\_z \cdot Q\_z \cdot f\_Corr\_z , \tag{4}$$

wobei

z            für Laden oder Entladen (wahlweise) steht;
$\Delta U$            einen Spannungshub des Aktors repräsentiert, welcher vom Raildruck abhängig ist;
Q            die elektrische geflossene Ladung; und
f_Corr_z    einen Korrekturfaktor

repräsentiert.

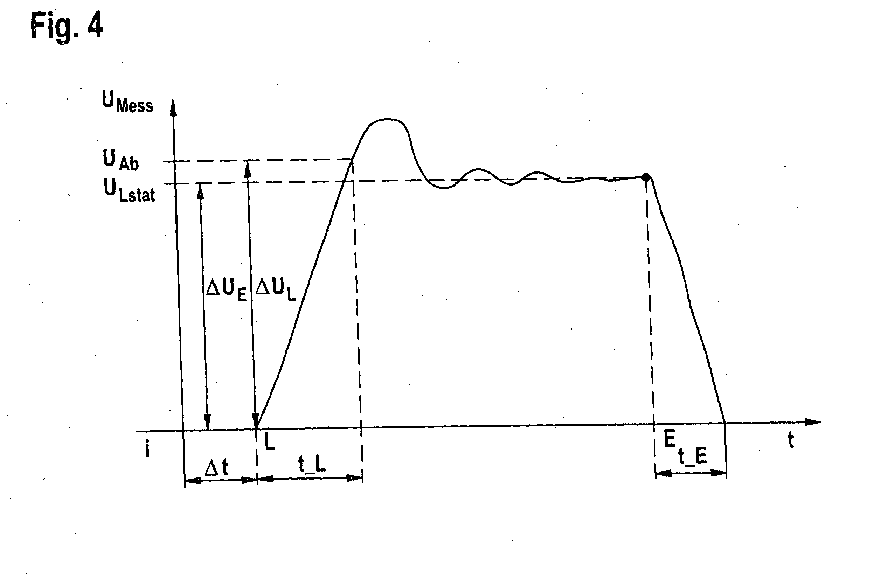

Der Spannungshub $\Delta U$ repräsentiert während eines Ladevorganges L die Differenz zwischen der Abschaltspannung $U_{Ab}$ und 0 V und bei einem Entladevorgang E die Differenz zwischen der stationären Endspannung $U_{Lstat}$ und 0 V, wie dies in Figur 4 veranschaulicht ist. Mit der Einführung des Korrekturfaktors f_Corr_z ist es möglich, die Ladebeziehungsweise Entladeenergie $W_{Li}$, $W_{Ei}$ aus dem Spannungshub $\Delta U$ und der geflossenen Ladung Q eines Ladebeziehungsweise Entladezyklus zu berechnen, wie dies in der Energiemesseinrichtung 142 erfolgt.

Durch die Berechnung der Aktorenergie wie oben beschrieben ist es möglich, auch auf einen veränderten Energiebedarf und somit einen möglichen Defekt des Aktors frühzeitig rückzuschließen. Ein solcher Defekt zeigt sich insbesondere durch einen Energiebedarf, der oberhalb eines spezifizierten Energiebedarfs für diesen Aktor liegt. Wird der Energiebedarf nicht aus kontinuierlich gemessenen Spannungen und Strömen am Piezo-Aktor 130-1 ... 130-$n_{zyl}$, sondern nur gemäß den Gleichungen (3) oder (4) berechnet, so sind die von dem genauen Verlauf der Ladebeziehungsweise Entladekurven abhängigen Korrekturfaktoren f_Corr_laden und f_Corr_entladen bereits bei der Entwicklung durch eine Referenzmessung zu ermitteln. Kommen verschiedene Lade- beziehungsweise Entladekurven zum Einsatz, so ist dies entsprechend durch verschiedene Korrekturfaktoren zu berücksichtigen. In diesem Falle sind die Korrekturfaktoren f_Corr_z z keine Konstanten, sondern Parameter, welche von den die jeweilige Kurvenform bestimmenden Werten abhängen. Diese Werte sind typischerweise der Spannungshub $\Delta U\_z$, die mechanische Gegenkraft $F\_A$ am Piezo-Aktor und der Aktorhub $\Delta 1$.

Wenn eine exakte Bestimmung der oben genannten Korrekturfaktoren nicht möglich ist, kann kein absoluter Energiebedarf, sondern nur ein mit dem Energiebedarf korrelierender Ersatzwert ermittelt werden. Dennoch ist es mit diesem aktuellen Ersatzwert möglich, Abweichungen von einem definierten nominellen Ersatzwert zu erkennen und diese Abweichungen in Form des Steuersignals von der Regelungseinrichtung 140 an die Leistungsbegrenzungseihrichtung 129 zu übermiteln, damit diese Einrichtung eine geeignete Reduzierung der Leistung veranlasst.

In Figur 4 ist der Verlauf der Messspannung $U_{Mess}$ zur Realisierung einer einzelnen Einspritzung innerhalb eines Einspritzzyklus graphisch veranschaulicht. Es ist zu erkennen, dass der Ladevorgang L nach einer gewissen

Verzögerungszeit $\Delta t$ beginnt und danach durch einen im Wesentlichen linearen Anstieg der gemessenen Spannung $U_{Mess}$ und damit der dem Aktor zugeführten Spannung gekennzeichnet ist. Sobald die Spannung über dem Aktor eine von dem Steuergerät 120 vorgegebene Abschaltspannungsschwelle $U_{Ab}$ erreicht hat, ist der Ladevorgang beendet und die-Spannungsversorgung durch das Steuergerät wird über die Schalteinrichtung 126 abgeschaltet. Ungeachtet dessen führt die Spannung über dem Aktor jedoch noch ein kurzzeitiges Überschwingen durch, bis sie sich schließlich auf die Größe einer stationären Ladeendspannung $U_{Lstat}$ einpendelt. Diese stationäre Ladeendspannung $U_{Lstat}$ wird bis zum Beginn eines vorgegebenen Entladezeitpunktes, siehe die rechte vertikale gestrichelte Linie in Figur 4, beibehalten. Ab diesem Zeitpunkt wird ein Entladevorgang E eingeleitet, welcher durch einen im Wesentlichen linearen Abfall der Spannung über dem Aktor auf null gekennzeichnet ist.

Sowohl die erfasste Messspannung $U_{Mess}$ und der gemessene Strom $I_i$, wie auch die von der Energiemesseinrichtung 142 berechnete aufgenommene und abgegebene Energie $W_{Li}$, $W_{Lei}$, werden einem Plausibilitätstest unterzogen. Dafür werden sie jeweils mit individuell geeigneten Schwellenwerten verglichen und im Falle eines Über- beziehungsweise Unterschreitens dieser Messwerte erfolgt eine Fehlerstatusmeldung. Für die Durchführung des Schwellenwertvergleiches und die gegebenenfalls erforderliche Generierung der Fehlerstatusmeldung ist in der Regeleinrichtung 140 für die Signale, welche die von einem Aktor aufgenommene und abgegebene Energie repräsentieren, eine Energiediagnoseeinrichtung 149 vorgesehen. Sie erzeugt eine Fehlerstatusmeldung genau dann, wenn die von einem Aktor aufgenommene elektrische Energie $W_{Li}$ größer als ein vorgegebener Schwellenwert $\hat{W}_{max}$ ist, welcher die maximal zulässige Ladeenergie repräsentiert, oder kleiner ist als ein weiterer vorgegebener Schwellenwert $\hat{W}min$, welcher die minimal zulässige Ladeenergie repräsentiert.

Ähnliche Fehlermeldungen werden von der Energiediagnoseeinrichtung 149 dann erzeugt, wenn die von einem Aktor während eines Entladevorganges E abgegebene elektrische Energie oder der aus der Differenz zwischen aufgenommener und abgegebener Energie ermittelte Energieverbrauch $\Delta Wi$ für eine Einspritzung jeweils vorgegebene Minimal- und Maximalschwellenwerte unterbeziehungsweise überschreiten.

Typischerweise werden bei einer Brennkraftmaschine baugleiche Piezo-Aktoren eingesetzt, von denen jeweils mehrere, insbesondere zwei, von einer gemeinsamen Messeinrichtung überwacht werden. Wenn bei einer derartigen Konfiguration festgestellt wird, dass der von einer Messeinrichtung festgestellte Energieverbrauch aller an sie angeschlossenen Aktoren ansteigt gegenüber dem Energieverbrauch, welchen eine andere Messeinrichtung für die restlichen Aktoren ermittelt hat, so lässt dies auf einen Fehler innerhalb der Messeinrichtung schließen. Ein derartiger Fehler kann dann durch eine geeignete Korrektur beziehungsweise ein geeignetes Anpassen des von der einen Messeinrichtung fehlerhaft ermittelten Energieverbrauches korrigiert werden.

Ist es nicht möglich, den absoluten Energieverbrauch eines Aktors zu bestimmen, so kann dennoch eine Drift in dem Energieverbrauch eines Aktors gegenüber anderen Aktoren erkannt werden. Wird weiterhin vorausgesetzt, dass alle Aktoren grundsätzlich einen nominellen Energieverbrauch haben, so kann der Energieverbrauch desjenigen Aktors mit abweichendem Energieverbrauch zu den Energieverbräuchen der anderen Aktoren ins Verhältnis gesetzt werden und auf diese Weise ebenfalls ermittelt werden. Eine gemeinsame, altersbedingte Drift im Energieverbrauch aller Aktoren kann durch das erfindungsgemäße Verfahren prinzipbedingt nicht erkannt werden.

Ungeachtet des Plausibilisierungstests und der Generierung von Fehlermeldungen wird der innerhalb der Regelungseinrichtung 140 ermittelte Energieverbrauch $\Delta W_i$, das heißt der Energiebedarf eines Aktors für eine Einspritzung mit Hilfe der Subtraktionseinrichtung 143 gebildet und anschließend in einer Mittelungseinrichtung 144 über alle Aktoren 130-1...130-$n_{zyl}$, deren Gesamtanzahl der Einfachheit halber als identisch mit der Gesamtanzahl der Zylinder $n_{zyl}$ der Brennkraftmaschine angesehen wird, gemittelt. Der auf diese Weise berechnete mittlere Energieverbrauch $\Delta \overline{W}$ für eine Einspritzung pro Aktor wird nachfolgend in einen mittleren Leistungsverbrauch $\overline{P}$ vorzugsweise aller Aktoren umgerechnet. Dazu wird der berechnete mittlere Energieverbrauch $\Delta \overline{W}$ pro Aktor zunächst in einem Zeitfilter 145 gefiltert, insbesondere zeitlich gemittelt und nachfolgend mit einem Korrekturfaktor C multipliziert, der die Anzahl der Einspritzungen pro Zeiteinheit repräsentiert. Der Korrekturfaktor C berechnet sich als Produkt aus der Drehzahl n der Brennkraftmaschine, der Anzahl der Zylinder beziehungsweise der Anzahl der Aktoren $n_{zyl}$, der Anzahl der Einspritzungen dividiert durch die Zahl 2, wenn bei der Brennkraftmaschine nur bei jeder zweiten Kurbelwellenumdrehung eine Zündung erfolgt (4-Takt-Motor), und dividiert durch den Faktor 60 zur Umrechnung von der Einheit "Minuten" auf die Einheit "Sekunden". Mathematisch ausgedrückt berechnet sich die verbrauchte mittlere Leistung P aller Aktoren gemäß folgender Gleichungen (5) und (6):

$$\overline{P} = \overline{\Delta W}_{akt} \left[ \frac{J}{Einspritzung} \right] \cdot C \; , \qquad\qquad (5)$$

mit

$$C = \frac{n \cdot n_{zyl} \cdot n_{Inj}}{2 \cdot 60} \left[ \frac{Einspritzungen}{s} \right] \qquad\qquad (6)$$

wobei

$\overline{P}$ die mittlere, durch vorzugsweise alle Aktoren verbrauchte elektrische Leistung;

$\Delta \overline{W}_{akt}$ den mittleren Energieverbrauch pro Aktor der Brennkraftmaschine für jeweils eine Einspritzung am Ausgang des Zeitfilters 145;

C einen Korrekturfaktor;

n die Drehzahl der Brennkraftmaschine;

$n_{zyl}$ die Anzahl vorzugsweise aller Zylinder beziehungsweise die Anzahl der Aktoren der Brennkraftmaschine;

$n_{Inj}$ die Anzahl der Einspritzungen pro Einspritzzyklus;

2 einen Faktor, welcher berücksichtigt, dass bei der Brennkraftmaschine nur jede zweite Kurbelwellenumdrehung eine Einspritzung erfolgt; und

60 einen Faktor zur Umrechung von Minuten in Sekunden repräsentiert.

Für die Berechnung dieses Korrekturfaktors C sind in Figur 3 die Multiplikationseinrichtung 147 und die Divisionseinrichtung 148 vorgesehen. Der mit Hilfe dieser Einrichtungen auf die oben beschriebene Weise berechnete Leistungsverbrauch beziehungsweise Leistungsbedarf $\overline{P}$ von $n_{zyl}$ Aktoren für $n_j$ Einspritzungen wird dem Steuergerät 120 als Steuer- beziehungsweise Regelgröße zugeführt.

Innerhalb des Steuergerätes 120 ist eine Leistungsbegrenzungseinrichtung 129 vorgesehen, welche diese Steuergröße mit einer vorgegebenen Sollgröße vergleicht. Bei dieser Sollgröße $\overline{P}_{soll}$ kann es sich entweder um die nominelle Abgabeleistung des Steuergerätes beziehungsweise insbesondere der DC/DC-Wandlereinrichtung 122 oder um eine zu Beginn, das heißt beim Start der Brennkraftmaschine gemessene Wandlerleistung handeln. Letztere stellt einen korrelierenden Ersatzwert für die nominelle Abgabeleistung des Wandlers dar. Während die nominelle Abgabeleistung des Wandlers einen Absolutwert repräsentiert, handelt es sich bei der gemessenen Wandlerleistung um eine relative Größe, welche durch die Leistungsbegrenzungseinrichtung 129 im Umfang einer prozentualen Umgebung eingehalten werden muss.

Wenn die Leistungsbegrenzungseinrichtung 129 feststellt, dass der Leistungsbedarf der Aktoren größer ist als die vorgegebene Sollgröße, so erzeugt sie ein steuergeräteinternes Steuersignal, welches eine Reduzierung des Leistungsbedarfs der Aktoren veranlasst. Dies kann grundsätzlich auf verschiedene Weise erfolgen. Die erfindungsgemäß bevorzugte Vorgehensweise zur Reduzierung des Leistungsbedarfs der Aktoren besteht darin, dass im Rahmen eines Einspritzzyklus einzelne Nebeneinspritzungen weggelassen werden. Diese Vorgehensweise bietet den Vorteil, dass die damit verbundenen Einschränkungen für den Fahrer eines Kraftfahrzeugs mit der entsprechenden eingebauten Brennkraftmaschine minimal sind. Das Fahrzeug wäre weiterhin fahrbereit; eine mögliche Auswirkung wäre zum Beispiel ein höheres Verbrennungsgeräusch. Diese Vorgehensweise wird deswegen bevorzugt, weil sie im Vergleich zu anderen nachfolgend aufgezeigten Möglichkeiten zur Reduzierung des Leistungsbedarfs für den Fahrer die geringsten Einschränkungen mit sich bringt. Maßnahmen mit stärkeren Einschränkungen für den Fahrer wären zum Beispiel die Begrenzung der Drehzahl n der Brennkraftmaschine, das komplette Abschalten eines Aktors und damit eines Zylinders oder die Reduzierung einer Aktorspannung, was zwangsläufig auch zu einem Ausfall des entsprechenden Aktors führen würde. Die letztgenannten drei Maßnahmen haben alle den Nachteil, dass sie für den Fahrer deutlich spürbare Einschränkungen in der Fahrleistung des Kraftfahrzeug mit sich bringen.

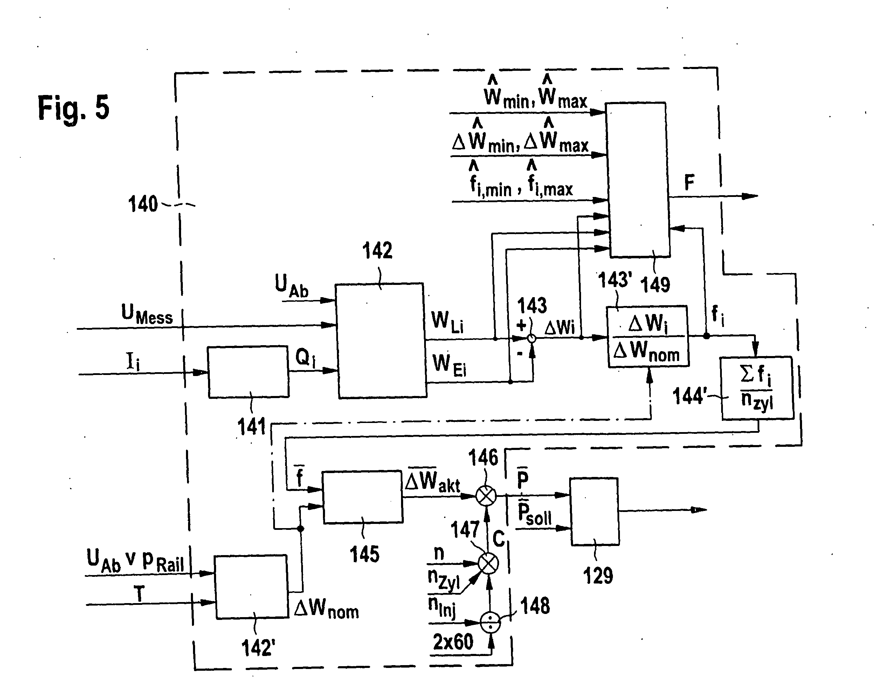

Figur 5 zeigt ein zweites Ausführungsbeispiel für die erfindungsgemäße Regelungseinrichtung 140. Es unterscheidet sich von dem ersten Ausführungsbeispiel lediglich dadurch, dass es eine zweite alternative Möglichkeit zur Berechnung der von vorzugsweise allen Aktoren 130-1...-$n_{zyl}$ der Brennkraftmaschine verbrauchten mittleren elektrischen Leistung $\overline{P}$ veranschaulicht.

Bei dem zweiten Ausführungsbeispiel erfolgt die Berechnung des mittleren Energieverbrauchs $\Delta W_i$ für eine Einspritzung bei einem einzelnen Aktor genauso wie oben unter Bezugnahme auf Figur 3 beschrieben mit Hilfe der Energiemesseinrichtung 142. Auch die Durchführung eines Schwellenwertvergleiches dieses mittleren Energieverbrauchs mit einem unteren Schwellenwert $\Delta W_{min}$ und einem oberen Schwellenwert $\Delta W_{max}$ innerhalb der Energiediagnoseeinrichtung 149 erfolgt bei dem zweiten Ausführungsbeispiel analog wie bei dem ersten Ausführungsbeispiel.

Das zweite Ausführungsbeispiel unterscheidet sich allerdings von dem ersten Ausführungsbeispiel in der Berechnung des gesuchten mittleren Leistungsverbrauches $\overline{P}$ beziehungsweise genauer gesagt in der Berechnung des für die Berechnung der mittleren verbrauchten Leistung $\overline{P}$ aller ktoren aktuell bestimmten Energieverbrauchs $\overline{\Delta W}_{akt}$ pro Aktor. Gemäß dem zweiten Ausführungsbeispiel wird dieser aktuell bestimmte Energieverbrauch $\overline{\Delta W}_{akt}$ in der Weise berechnet, dass zunächst während eines vorbestimmten Zeitintervalls nach dem Start der Brennkraftmaschine der gemessene Energieverbrauch $\Delta W_i$ in einer Normierungseinrichtung 143' vorzugsweise regelmäßig auf einen nominellen Energieverbrauch $\Delta W_{nom}$ normiert wird. Das Ergebnis dieser Normierung wird nachfolgend als Abweichungsfaktor $f_i$ bezeichnet.

Der nominelle Energieverbrauch $\Delta W_{nom}$ berechnet sich in einer abgewandelten Energiemesseinrichtung 142' aus der aktuellen Aktortemperatur T und der aktuellen Abschaltspannung $U_{Ab}$ des Aktors oder alternativ zu der Abschaltspannung aus dem Raildruck $p_{Rail}$. Die Berechnung des nominellen Energieverbrauches $\Delta W_{nom}$ pro Aktor aus den genannten Größen erfolgt mit Hilfe von hinterlegten Kennlinien. Weil sowohl die Abschaltspannung $U_{Ab}$ wie auch der Raildruck $P_{rail}$ und die Temperatur des Aktors von dem jeweiligen Betriebspunkt der Brennkraftmaschine abhängen, ist auch der nominelle Energieverbrauch $\Delta W_{nom}$ pro Aktor abhängig von dem aktuellen Arbeitspunkt der Brennkraftmaschine.

Der oben berechnete Abweichungsfaktor $f_i$ ist im Unterschied zu dem mittleren Energieverbrauch und zu dem nominellen Energieverbrauch $\Delta W_{nom}$ unabhängig vom Arbeitspunkt der Brennkraftmaschine und sollte idealerweise bei eins liegen. Diese Unabhängigkeit des Abweichungsfaktors $f_i$ von dem aktuellen Arbeitspunkt der Brennkraftmaschine resultiert daraus, dass sowohl der Zähler wie auch der Nenner zur Berechnung des Abweichungsfaktors $f_i$ in der Normierungseinrichtung 143' jeweils von dem aktuellen Arbeitspunkt der Brennkraftmaschine abhängig sind; aufgrund der Quotientenbildung kürzt sich diese Abhängigkeit dann für den resultierenden Abweichungsfaktor heraus. Aufgrund dieser fehlenden Abhängigkeit vom Arbeitspunkt stellt der Abweichungsfaktor $f_i$ ein wesentlich aussagekräftigeres und sehr viel einfacher zu handhabendes Maß für eine eventuelle Änderung des Energieverbrauchs eines Aktors als der reine gemessene Energieverbrauch $\Delta W_i$ dar. Abweichungen vom nominalen Energieverbrauch können so bereits festgestellt werden, bevor der gemessene Energieverbrauch absolute Grenzen überschreitet.

Der Abweichungsfaktor $f_i$ wird vorzugsweise in der Energiediagnoseeinrichtung 149 dahingehend überwacht, ob er einen für ihn vorgegebenen unteren Schwellenwert $\hat{f}_{i,min}$ unterschreitet oder einen für ihn vorgegebenen oberen Schwellenwert $\hat{f}_{i,max}$ überschreitet. In diesem Fällen erzeugt die Energiediagnoseeinrichtung 149 ein Fehlersignal F.

Eine regelmäßige Neuberechnung beziehungsweise Aktualisierung des Abweichungsfaktors $f_i$ erfolgt vorzugsweise nur während des besagten vorgegebenen Zeitintervalls nach dem Start der Brennkraftmaschine, weil nur während dieses Zeitintervalls ein für eine sinnvolle Berechnung des mittleren Energieverbrauches $\Delta W_i$ erforderlicher Messabgleich möglich ist. Nach Ablauf dieses Zeitintervalls wird der Abweichungsfaktor $f_i$ auf einen dann aktuellen Wert eingefroren.

Unabhängig davon, ob der Faktor $f_i$ eingefroren ist oder nicht, wird er in einer abgewandelten Mittelungseinrichtung 144' über die Anzahl der Zylinder $n_{zyl}$ beziehungsweise die Anzahl der Aktoren der Brennkraftmaschine gemittelt.

In einem abgewandelten Zeitfilter 145' der Regelungseinrichtung 140 wird der über die Anzahl der Zylinder $n_{zyl}$ beziehungsweise Aktoren gemittelte Abweichungsfaktor $\overline{f}$ zusätzlich einer zeitlichen Filterung, insbesondere Mittelung unterzogen, woraus dann ein zeitlich gemittelter Abweichungsfaktor $\overline{f}_t$ resultiert. In dem Zeitfilter 145' wird dieser zeitlich gemittelte bweichungsfaktor $\overline{f}_t$ dazu verwendet, um einen aktuell bestimmten mittleren Energieverbrauch $\overline{\Delta W}_{akt}$ pro Aktor zu bestimmen. Dies erfolgt in der Weise, dass der zeitlich gemittelte Abweichungsfaktor $\overline{f}_t$ mit dem in der abgewandelten Energiemesseinrichtung 142' berechneten mittleren nominellen Energieverbrauch $\Delta W_{nom}$ pro Aktor multipliziert wird.

Während der Abweichungsfaktor $f_i$ sowie der gemittelte Abweichungsfaktor $\overline{f}$ nur während des besagten Zeitintervalls nach dem Start der Brennkraftmaschine regelmäßig neu berechnet und auf diese Weise aktualisiert werden und nach Ablauf des Zeitintervalls konstant gehalten werden, ist eine sinnvolle Berechnung des nominellen Energieverbrauchs $\Delta W_{nom}$ pro Aktor auch nach Ablauf des Zeitintervalls noch möglich. Aufgrund der beschriebenen Produktbildung innerhalb des abgewandelten Zeitfilters 145' wird damit auch der aktuell bestimmte Energieverbrauch $\overline{\Delta W}_{akt}$ pro Aktor auch nach Ablauf des besagten Zeitintervalls ständig aktualisiert.

Die Berechnung der mittleren verbrauchten Leistung $\overline{P}$ vorzugsweise aller Aktoren der Brennkraftmaschine erfolgt dann analog zu dem ersten Ausführungsbeispiel durch Multiplikation des aktuell bestimmten Energieverbrauchs pro Aktor $\overline{\Delta W}_{akt}$ mit dem Korrekturfaktor C. Auch der nachfolgende Soll/Istwertvergleich zwischen der mittleren verbrauchten Leistung $\overline{P}$ und der Sollleistung $\overline{P}_{soll}$ gemäß Block 129 erfolgt genau wie bei dem ersten Ausführungsbeispiel.

Die soeben beschriebenen Verfahren zum Betreiben der Brennkraftmaschine werden vorzugsweise jeweils in Form eines Computerprogramms realisiert, welches dann auf der Vorrichtung 100 und insbesondere auf dem Steuergerät 120 abläuft. Das Computerprogramm kann gegebenenfalls zusammen mit weiteren Computerprogrammen für das Steuergerät auf einem computerlesbaren Datenträger abgespeichert sein. Bei dem Datenträger kann es sich um eine Diskette, eine Compact Disc, einen sogenannten Flash-Memory oder dergleichen handeln. Die auf dem Datenträger gespeicherte Software kann dann als Produkt an einen Kunden verkauft werden.

Alternativ dazu kann das Computerprogramm gegebenenfalls wiederum zusammen mit weiteren Computerprogrammen - ohne die Zuhilfenahme eines Datenträgers - über ein elektronisches Kommunikationsnetzwerk, insbesondere das Internet, als Produkt an einen Kunden übertragen und verkauft werden.

**Patentansprüche**

**1.** Verfahren zum Betreiben einer Brennkraftmaschine mit einer Mehrzahl ($n_{zyl}$) von Zylindern, welche von einem Steuergerät (120) über jeweils einen individuell zugeordneten Piezo-Aktor (130-1...130-$n_{zyl}$) angesteuert werden; **gekennzeichnet durch**

a. Erfassen der von vorzugsweise allen Piezo-Aktoren der Brennkraftmaschine insgesamt verbrauchten mittleren elektrischen Leistung ($\overline{P}$) (Verfahrensschritt S1);
b. Vergleichen dieser erfassten mittleren elektrischen Leistung mit einer vorgegebenen Soll-Leistung ($\overline{P}_{soll}$), welche die von dem Steuergerät an die Piezo-Aktoren abgebbare Nennleistung repräsentiert (Verfahrensschritt S2); und
c. Reduzieren der von den Piezo-Aktoren (130-1...130-$n_{zyl}$) zukünftig insgesamt verbrauchten elektrischen Leistung, wenn der Vergleich zeigt, dass die erfasste mittlere elektrische Leistung größer als die vorgegebene Soll-Leistung ($\overline{P}_{soll}$) ist (Verfahrensschritt S3);
wobei die Erfassung der von vorzugsweise allen Piezo-Aktoren ($N_A = n_{zyl}$) verbrauchten mittleren elektrischen Leistung ($\overline{P}$) folgenden Teilschritt umfasst:
d. Erfassen des Energieverbrauchs ($\Delta W_i$) eines einzelnen Piezo-Aktors für eine einzelne Einspritzung als Differenz der von dem Piezo-Aktor während eines Ladevorganges (L) für die Einspritzung aufgenommene Energie ($W_{Li}$) und der von dem Piezo-Aktor während eines nachfolgenden Entladevorgangs (E) abgegebenen Energie ($W_{Ei}$).

**2.** Verfahren nach Anspruch 1, **dadurch gekennzeichnet, dass** die Erfassung der von vorzugsweise allen Piezo-Aktoren ($N_A = n_{zyl}$) verbrauchten mittleren elektrischen Leistung ($\overline{P}$) folgende weitere Teilschritte umfasst:

a. Ermitteln eines mittleren Energieverbrauchs ($\Delta \overline{W}$) pro Piezo-Aktor (130-1...130-$n_{zyl}$) durch Aufsummieren der Energieverbräuche vorzugsweise aller Piezo-Aktoren und Dividieren der Summe durch die Anzahl der Piezo-Aktoren ($N_A = n_{zyl}$); und
b. Umrechnen des mittleren Energieverbrauchs $\Delta \overline{W}$ pro Piezo-Aktor in die verbrauchte mittlere Leistung ($\overline{P}$) vorzugsweise aller Piezo-Aktoren.

3. Verfahren nach Anspruch 1, **dadurch gekennzeichnet, dass** die Erfassung der von vorzugsweise allen Piezo-Aktoren ($N_A = n_{zyl}$) verbrauchten mittleren elektrischen Leistung ($\overline{P}$) folgende weitere Teilschritte umfasst:

a. Ermitteln eines Abweichungsfaktors ($f_i$) durch Dividieren des zylinderspezifischen Energieverbrauchs ($\Delta W_i$) durch einen nominellen Energieverbrauch ($\Delta W_{nom}$) pro Piezo-Aktor beziehungsweise pro Zylinder;
b. Berechnen eines über vorzugsweise alle Piezo-Aktoren gemittelten Abweichungsfaktors ($\overline{f}$) pro Piezo-Aktor durch Aufsummieren der Abweichungsfaktoren von vorzugsweise allen Piezo-Aktoren und Dividieren dieser Summe durch die Anzahl vorzugsweise aller Zylinder beziehungsweise Piezo-Aktoren;
c. zeitliche Mittelung des über die Piezo-Aktoren gemittelten Abweichungsfaktors und Berechnen eines aktuell bestimmten Energieverbrauches ($\overline{\Delta W_{akt}}$) pro Piezo-Aktor durch Multiplikation des zeitlich und über die Piezo-Aktoren gemittelten Abweichungsfaktors ($\overline{f_t}$) mit dem nominellen Energieverbrauch ($\Delta W_{nom}$); und
d. Umrechnen des so ermittelten aktuell bestimmten Energieverbrauchs ($\overline{\Delta W_{akt}}$) in die verbrauchte mittlere Leistung ($\overline{P}$) von vorzugsweise allen Piezo-Aktoren.

4. Verfahren nach Anspruch 2 oder 3, **dadurch gekennzeichnet, dass** der Energieverbrauch ($\Delta W_i$) eines einzelnen Piezo-Aktors (130-1...130-$n_{zyl}$) aus dem Verlauf der an ihm abfallenden Spannung ($U_{Mess}$) und der Veränderung seiner Ladung ($Q_i$) berechnet wird.

5. Verfahren nach Anspruch 2, 3 oder 4, **dadurch gekennzeichnet, dass** die Umrechung des aktuell bestimmten mittleren Energieverbrauchs ($\overline{\Delta W_{akt}}$) in die verbrauchte mittlere Leistung ($\overline{P}$) vorzugsweise aller Piezo-Aktoren gemäß folgender Gleichungen (5), (6) erfolgt:

$$\overline{P} = \overline{\Delta W_{akt}} \bullet C, \qquad\qquad (5)$$

mit

$$C = n \cdot n_{zyl} \cdot n_{Inj} / (2 \cdot 60) \left[ \frac{Einspritzzyklen}{s} \right], \qquad\qquad (6)$$

wobei
$\overline{P}$ die mittlere, durch die Piezo-Aktoren verbrauchte elektrische Leistung;
$\overline{W}_{akt}$ den aktuell bestimmten mittleren Energieverbrauch pro Piezo-Aktor der Brennkraftmaschine für jeweils eine Einspritzung;
C einen Korrekturfaktor;
n die Drehzahl der Brennkraftmaschine;
$n_{zyl}$ die Anzahl der Zylinder beziehungsweise die Anzahl der Piezo-Aktoren der Brennkraftmaschine;
$n_{Inj}$ die Anzahl der Einspritzungen pro Einspritzzyklus;
2 einen Faktor, welcher berücksichtigt, dass bei der Brennkraftmaschine nur jede zweite Kurbelwellenumdrehung eine Einspritzung erfolgt; und
60 einen Faktor zur Umrechnung von Minuten in Sekunden repräsentiert.

6. Verfahren nach einem der vorangegangenen Ansprüche, **dadurch gekennzeichnet, dass** die von dem Steuergerät vorgegebene Soll-Leistung $\overline{P}$ der nominellen Abgabeleistung des Steuergerätes (120) beziehungsweise einer DC/DC-Wandler-Einrichtung (122) entspricht.

7. Verfahren nach einem der Ansprüche 1 - 6, **dadurch gekennzeichnet, dass** die vorgegebene Soll-Leistung $\overline{P}_{soll}$ des Steuergerätes einer bei einem Start des Steuergerätes gemessenen Leistung der Wandlereinrichtung (122) entspricht.

8. Verfahren nach einem der vorangegangenen Ansprüche, **dadurch gekennzeichnet, dass** die von den Piezo-Aktoren (130-1...130-$n_{zyl}$) verbrauchte mittlere elektrische Leistung dadurch reduziert wird, dass bei mindestens einem der Piezo-Aktoren die Ansteuerungsfrequenz durch Weglassen niederprioer Einspritzungen verringert wird.

9. Verfahren nach einem der vorangegangenen Ansprüche, **dadurch gekennzeichnet, dass** die von den Piezo-Aktoren verbrauchte mittlere elektrische Leistung dadurch reduziert wird, dass mindestens ein Piezo-Aktor und damit gleichzeitig auch ein Zylinder abgeschaltet werden.

10. Verfahren nach einem der vorangegangenen Ansprüche, **dadurch gekennzeichnet, dass** die von den Piezo-Aktoren verbrauchte mittlere elektrische Leistung dadurch reduziert wird, dass die Drehzahl (n) der Brennkraftmaschine begrenzt wird.

11. Verfahren nach einem der vorangegangenen Ansprüche, **dadurch gekennzeichnet, dass** die von den Piezo-Aktoren verbrauchte elektrische Leistung dadurch reduziert wird, dass die Aktorspannung zur Ansteuerung von mindestens einem der Piezo-Aktoren $(130\text{-}1...130\text{-}n_{zyl})$ reduziert wird.

12. Verfahren nach einem der Ansprüche 2 - 11, **dadurch gekennzeichnet, dass** eine zylinderspezifische Fehlerstatusmeldung generiert wird, wenn

- die von einem der Piezo-Aktoren $(130\text{-}1...130\text{-}n_{zyl})$ während eines Ladevorganges aufgenommene Energie $(W_{Li})$ einen vorgegebenen ersten Schwellenwert $(\overline{W}_{max})$ überschreitet oder einen vorgegebenen zweiten Schwellenwert $(\overline{W}_{min})$ unterschreitet;
- die von dem Piezo-Aktor während eines Entladevorgangs abgegebene Energie $(W_{Ei})$ einen dritten Schwellenwert $(\overline{W}_{Emax})$ überschreitet oder einen vierten Schwellenwert $(\overline{W}_{Emin})$ unterschreitet; und/oder
- der Energieverbrauch $(\Delta W_i)$ eines Piezo-Aktors pro Einspritzung einen vorgegebenen fünften Schwellenwert $(\Delta \overline{W}_{min})$ überschreitet oder einen sechsten Schwellenwert $(\Delta \overline{W}_{min})$ unterschreitet.

13. Verfahren nach einem der Ansprüche 4 - 12, **dadurch gekennzeichnet, dass** für die zur Berechnung des Energieverbrauchs erfassten elektrischen Größen, wie Spannung, Strom oder Ladung, eine Plausibilitätsprüfung in der Weise vorgesehen wird, wonach die erfassten elektrischen Größen nur dann für die Berechnung des Energieverbrauchs verwendet werden, wenn sie innerhalb individueller, durch geeignete Schwellenwerte für sie vorgegebener Wertebereiche liegen.

14. Verfahren nach Anspruch 13, **dadurch gekennzeichnet, dass** die erfassten elektrischen Größen korrigiert werden, bevor sie für die Berechnung des Energieverbrauchs verwendet werden, wenn festgestellt wurde, dass die elektrischen Größen aufgrund eines Defektes der sie erfassenden Messeinrichtung fehlerhaft sind.

15. Computerprogramm mit Programmcode zur Ansteuerung einer Brennkraftmaschine, **dadurch gekennzeichnet, dass** der Programmcode ausgebildet ist zur Durchführung des Verfahrens nach einem der Ansprüche 1 - 14.

16. Datenträger mit einem Computerprogramm nach Anspruch 15.

17. Vorrichtung (100) zum Betreiben einer Brennkraftmaschine mit einer Mehrzahl von Zylindern $(n_{zyl})$, welche jeweils über Piezo-Aktoren $(130\text{-}1...130\text{-}n_{zyl})$ angesteuert werden; umfassend:

ein Steuergerät (120) zum individuellen Ansteuern der Piezo-Aktoren $(130\text{-}1...130\text{-}n_{zyl})$;
**gekennzeichnet durch**
eine Regelungseinrichtung (140) zum Erfassen der von vorzugsweise allen Piezo-Aktoren der Brennkraftmaschine verbrauchten mittleren elektrischen Leistung $(\overline{P})$ und Generieren eines Steuersignals für das Steuergerät (120), welches eine Anweisung an das Steuergerät (120) repräsentiert, eine Reduktion der von den Piezo-Aktoren $(130\text{-}1...130\text{-}n_{zyl})$ verbrauchten elektrischen Leistung zu bewirken, wenn festgestellt wird, dass die erfasste elektrische Leistung $(\overline{P})$ eine vorgegebene Soll-Leistung $(\overline{P}_{soll})$, welche die von dem Steuergerät (120) an die Piezo-Aktoren abgebbare Nennleistung repräsentiert, übersteigt;
wobei die Regelungseinrichtung (140) aufweist:

eine Ladungsmesseinrichtung (141) zum Erfassen der den einzelnen Piezo-Aktoren $(130\text{-}1... 130\text{-}n_{zyl})$ beziehungsweise Zylindern individuell zugeordneten Ladungen $(Q_I)$;
eine Energiemesseinrichtung (142) zum Berechnen der von einem Piezo-Aktor $(130\text{-}1... 130\text{-}n_{zyl})$ während eines Ladevorganges für eine einzelne Einspritzung aufgenommenen Energie $(W_{Li})$ und der von demselben Piezo-Aktor während eines Entladevorgangs (E) abgegebenen Energie $(W_{Ei})$; und
eine Subtraktionseinrichtung (143) zum Berechnen des zylinderspezifischen Energieverbrauchs $(\Delta Wi)$ als Differenz zwischen der aufgenommenen und der abgegebenen Energie.

**18.** Vorrichtung (100) nach Anspruch 17, **dadurch gekennzeichnet, dass** die Regelungseinrichtung (140) aufweist:

eine Mittelungseinrichtung (144) zum Ermitteln eines vorzugsweise über alle Piezo-Aktoren gemittelten Energieverbrauchs ($\Delta \overline{W}$) pro Piezo-Aktor;
ein Zeitfilter (145) zum zeitlichen Filtern, insbesondere Mitteln, des über die Piezo-Aktoren gemittelten Energieverbrauchs in einen aktuell bestimmten mittleren Energieverbrauch ($\overline{\Delta W_{akt}}$); und
eine Multiplikationseinrichtung (146) zum Berechnen einer mittleren Leistung (P) von vorzugsweise allen Piezo-Aktoren durch Multiplizieren des Energieverbrauchs ($\overline{\Delta W_{akt}}$) mit einem Korrekturfaktor C.

**19.** Vorrichtung (100) nach Anspruch 17, **dadurch gekennzeichnet, dass** die Regelungseinrichtung (140) aufweist:

eine abgewandelte Energiemesseinrichtung (142') zum Berechnen des nominellen Energieverbrauchs ($\Delta W_{nom}$) eines Piezo-Aktors;
eine Normierungseinrichtung (143') zum Normieren des zylinderspezifischen Energieverbrauchs ($\Delta W_i$) auf den nominellen Energieverbrauch ($\Delta W_{nom}$) resultierend in einem Abweichungsfaktor ($f_i$);
eine abgewandelte Mittelungseinrichtung (144') zum Ermitteln eines über vorzugsweise alle Zylinder beziehungsweise Piezo-Aktoren gemittelten Abweichungsfaktors ($\bar{f}$);
ein abgewandeltes Zeitfilter (145') zum zeitlichen Mitteln des vorzugsweise über alle Piezo-Aktoren gemittelten Abweichungsfaktors ($\bar{f}$) und zum Berechnen eines aktuell bestimmten Energieverbrauches ($\overline{\Delta W_{akt}}$) pro Piezo-Aktor durch Multiplikation des zeitlich gemittelten Abweichungsfaktors ($\bar{f}_c$) mit dem nominellen Energieverbrauch ($\Delta W_{nom}$); und
eine Multiplikationseinrichtung (146) zum Berechnen des die von vorzugsweise allen Piezo-Aktoren verbrauchte elektrische Leistung (P) repräsentierenden Steuersignals für das Steuergerät (120) durch Multiplizieren des aktuell bestimmten Energieverbrauchs ($\overline{\Delta W_{akt}}$) mit einem Korrekturfaktor C.

**20.** Vorrichtung (100) nach einem der Ansprüche 17 oder 19, **dadurch gekennzeichnet, dass** das Steuergerät (120) eine Leistungsbegrenzungseinrichtung (129) aufweist zum Begrenzen der mittleren, durch die Piezo-Aktoren (130-1...130-$n_{zyl}$) zusammen verbrauchten Leistung im Ansprechen auf das Steuersignal.

**21.** Vorrichtung nach Anspruch 20, **dadurch gekennzeichnet, dass** die Leistungsbegrenzungseinrichtung (129) ausgebildet ist, die durch die Piezo-Aktoren verbrauchte Leistung dadurch zu begrenzen, dass sie die Aktorspannung reduziert, die Drehzahl (n) der Brennkraftmaschine begrenzt, einzelne Piezo-Aktoren und damit Zylinder ganz abschaltet und/oder Nebeneinspritzungen bei einzelnen Einspritzzyklen weglässt.

**22.** Vorrichtung nach einem der Ansprüche 17 - 21, **dadurch gekennzeichnet, dass** die Regelungseinrichtung (140) eine Energiediagnoseeinrichtung (149) aufweist zum Generieren einer Fehlerstatusmeldung (F) für einen Piezo-Aktor, wenn die von diesem Piezo-Aktor aufgenommene oder abgegebene Energie, dessen Energieverbrauch oder der Abweichungsfaktor ($f_i$) vorgegebene Schwellenwerte über- oder unterschreitet.

## Claims

**1.** Method for operating an internal combustion engine having a multiplicity ($n_{cyl}$) of cylinders which are actuated by a control unit (120) by means of, in each case, an individually assigned piezo-actuator (130-1...130-$n_{cyl}$), **characterized by**

a. measuring of the total average electrical power ($\overline{P}$) which is consumed by preferably all the piezo-actuators of the internal combustion engine (method step S1);
b. comparison of this measured average electrical power with a predefined setpoint power ($\overline{P}_{setp}$) which represents the rated power which can be output by the control unit to the piezo-actuators (method step S2); and
c. reduction of the total electrical power which is consumed in future by the piezo-actuators (130-1...130-$n_{cyl}$) if the comparison indicates that the measured average electrical power is greater than the predefined setpoint power ($\overline{P}_{setp}$) (method step S3);
wherein the measuring of the average electrical power ($\overline{P}$) which is consumed by preferably all the piezo-actuators ($N_A = n_{cyl}$) comprises the following substep d. measuring of the energy consumption ($\Delta W_i$) of an individual piezo-actuator for an individual injection as a difference between the energy ($W_{Li}$) taken up by the piezo-actuator during a charging process (L) for the injection and the energy ($W_{E1}$) output by the piezo-actuator during a subsequent discharging process (E).

**2.** Method according to Claim 1, **characterized in that** the measuring of the average electrical power ($\overline{P}$) which is consumed by preferably all the piezo-actuators ($N_A = n_{cyl}$) comprises the following substeps:

    a. obtaining an average energy consumption ($\Delta \overline{W}$) per piezo-actuator (130-1...130-$n_{cyl}$) by summing the energy consumption values of preferably all the piezo-actuators and dividing the sum by the number of the piezo-actuators ($N_A = n_{cyl}$) ; and
    b. converting the average energy consumption $\Delta \overline{W}$ per piezo-actuator into the consumed average power ($\overline{P}$) of preferably all the piezo-actuators.

**3.** Method according to Claim 1, **characterized in that** the measuring of the average electrical power ($\overline{P}$) which is consumed by preferably all the piezo-actuators ($N_A = n_{cyl}$) preferably comprises the following substeps:

    a. obtaining a deviation factor ($f_i$) by dividing the cylinder-specific energy consumption ($\Delta W_i$) by a nominal energy consumption ($\Delta W_{nom}$) per piezo-actuator or per cylinder;
    b. calculating a deviation factor ($\bar{f}$), preferably averaged over all the piezo-actuators, per piezo-actuator by summing the deviation of preferably all the piezo-actuators and dividing this sum by the number of preferably all the cylinders or piezo-actuators;
    c. averaging over time the deviation factor which is averaged over the piezo-actuators and calculating a currently determined energy consumption ($\overline{\Delta W_{cur}}$) per piezo-actuator by multiplying the deviation factor ($\bar{f}_c$), averaged over time and over the piezo-actuators, by the nominal energy consumption ($\Delta W_{nom}$); and
    d. converting the currently determined energy consumption ($\overline{\Delta W_{cur}}$), which is obtained in this way, into the consumed average power ($\overline{P}$) of preferably all the piezo-actuators.

**4.** Method according to Claim 2 or 3, **characterized in that** the energy consumption ($\Delta W_i$) of an individual piezo-actuator (130-1...130-$n_{cyl}$) is calculated from the profile of the voltage ($U_{meas}$) dropping across it and the change in its charge ($Q_i$).

**5.** Method according to Claim 2, 3 or 4, **characterized in that** the conversion of the currently determined average energy consumption ($\overline{\Delta W_{cur}}$) into the consumed average power ($\overline{P}$) of preferably all the piezo-actuators is carried out according to the following equations (5), (6):

$$\bar{P} = \overline{\Delta W_{cur}} \bullet C, \qquad\qquad\qquad (5)$$

with

$$C = n \cdot n_{cyl} \cdot n_{inj} / (2 \cdot 60) \left[ \frac{Injection\ cycle}{s} \right]. \qquad\qquad (6)$$

where

    ($\overline{P}$) represents the average electrical power consumed by the piezo-actuators;
    $W_{cur}$ represents the currently determined average energy consumption per piezo-actuator of the internal combustion engine for one injection in each case;
    C represents a correction factor;
    n represents the rotational speed of the internal combustion engine;
    $n_{cyl}$ represents the number of cylinders or the number of piezo-actuators of the internal combustion engine;
    $n_{inj}$ represents the number of injections per injection cycle;
    2 represents a factor which takes into account the fact that in the internal combustion engine an injection takes place only at every second revolution of the crank shaft; and
    60 represents a factor for converting minutes into seconds.

**6.** Method according to one of the preceding claims, **characterized in that** the setpoint power ($\overline{P}$) which is predefined by the control unit corresponds to the nominal output power of the control unit (120) or of a DC/DC converter device (122).

7. Method according to one of Claims 1-6, **characterized in that** the predefined setpoint power $(\overline{P}_{setp})$ of the control unit corresponds to a power of the converter device (122) which is measured when the control unit starts.

8. Method according to one of the preceding claims, **characterized in that** the average electrical power which is consumed by the piezo-actuators (130-1...130-$n_{cyl}$) is reduced by the fact that in at least one of the piezo-actuators the actuation frequency is reduced by omitting low-priority injections.

9. Method according to one of the preceding claims, **characterized in that** the average electrical power which is consumed by the piezo-actuators is reduced by the fact that at least one piezo-actuator and therefore at the same time also a cylinder are switched off.

10. Method according to one of the preceding claims, **characterized in that** the average electrical power which is consumed by the piezo-actuators is reduced by the fact that the rotational speed (n) of the internal combustion engine is limited.

11. Method according to one of the preceding claims, **characterized in that** the electrical power which is consumed by the piezo-actuators is reduced by the fact that the actuator voltage is reduced for actuating at least one of the piezo-actuators (130-1...130-$n_{cyl}$).

12. Method according to one of Claims 2-11, **characterized in that** a cylinder-specific fault status message is generated if

   - the energy ($W_{Li}$) which is taken up by one of the piezo-actuators (130-1...130-$n_{cyl}$) during a charging process exceeds a predefined first threshold value $(\overline{W}_{max})$ or undershoots a predefined second threshold value $(\overline{W}_{min})$;
   - the energy ($W_{Ei}$) which is output by the piezo-actuator during a discharging process exceeds a third threshold value $(\overline{W}_{Emax})$ or undershoots a fourth threshold value $(\overline{W}_{Emin})$; and/or
   - the energy consumption ($\Delta W_i$) of a piezo-actuator exceeds, per injection, a predefined fifth threshold value $(\Delta \overline{W}_{min})$ or undershoots a sixth threshold value $(\Delta \overline{W}_{min})$.

13. Method according to one of Claims 4-12, **characterized in that** for the electrical variables, such as the voltage, current or charge, which are measured for the calculation of the energy consumption, plausibility checking is provided in such a way that the measured electrical variables are used for the calculation of the energy consumption only when they are within individual value ranges predefined for them by means of suitable threshold values.

14. Method according to Claim 13, **characterized in that** the measured electrical variables are corrected before they are used for the calculation of the energy consumption if it has been stated that the electrical variables are incorrect owing to a defect in the measuring device measuring them.

15. Computer program having a program code for actuating an internal combustion engine, **characterized in that** the program code is designed to carry out the method according to one of Claims 1-14.

16. Data carrier having a computer program according to Claim 15.

17. Device (100) for operating an internal combustion engine having a multiplicity of cylinders ($n_{cyl}$) which are each actuated by means of piezo-actuators (130-1...130-$n_{cyl}$); comprising:

   a control unit (120) for individually actuating the piezo-actuators (130-1...130-$n_{cyl}$);
   **characterized by**
   a control device (140) for measuring the average electrical power $(\overline{P})$ which is consumed by preferably all the piezo-actuators of the internal combustion engine and generating a control signal for the control unit (120), which control signal represents an instruction to the control unit (120) to bring about a reduction in the electrical power which is consumed by the piezo-actuators (130-1...130-$n_{cyl}$) if it is detected that the measured electrical power $(\overline{P})$ exceeds a predefined setpoint power $(\overline{P}_{setp})$ which represents the nominal power which can be output to the piezo-actuators by the control unit (120);
   wherein the control device (140) has:

   a charge-measuring device (141) for measuring the chargers ($Q_1$) which are individually assigned to the individual piezo-actuators (130-1...130-n$_{cyl}$) or cylinders;
an energy-measuring device (142) for calculating the energy (W$_{Li}$) which is taken up by a piezo-actuator (130-1...130-n$_{cyl}$) during a charging process for an individual injection, and the energy (W$_{Ei}$) which is output by the same piezo-actuator during a discharging process (E); and
a subtraction device (143) for calculating the cylinder-specific energy consumption ($\Delta$W$_i$) as the difference between the taken-up energy and the output energy.

18. Device (100) according to Claim 17, **characterized in that** the control device (140) has:

an averaging device (144) for obtaining an energy consumption ($\Delta\overline{\mathbf{W}}$), preferably averaged over all the piezo-actuators, per piezo-actuator;
a time filter (145) for chronologically filtering, in particular averaging, the energy consumption averaged over the piezo-actuators, into a currently determined average energy consumption ($\Delta\overline{\mathbf{W}}_{cur}$); and
a multiplication device (146) for calculating an average power (P) of preferably all the piezo-actuators by multiplying the energy consumption ($\Delta\overline{\mathbf{W}}_{cur}$) by a correction factor C.

19. Device (100) according to Claim 17, **characterized in that** the control device (140) has:

a converted energy-measuring device (142') for calculating the nominal energy consumption ($\Delta$W$_{nom}$) of a piezo-actuator;
a standardization device (143') for standardizing the cylinder-specific energy consumption ($\Delta$W$_i$) to the nominal energy consumption ($\Delta$W$_{nom}$) resulting in a deviation factor (f$_i$);
a converted averaging device (144') for obtaining a deviation factor ($\overline{f}$) averaged over preferably all the cylinders or piezo-actuators;
a converted time filter (145') for chronologically averaging the deviation factor ($\overline{f}$) preferably averaged over all the piezo-actuators and for calculating a currently determined energy consumption ($\Delta\overline{\mathbf{W}}_{cur}$) per piezo-actuator by multiplying the chronologically averaged deviation factor ($\overline{\mathbf{f}}_{t}$) by the nominal energy consumption ($\Delta$W$_{nom}$) ; and
a multiplication device (146) for calculating the control signal, representing the electrical power (P) which is consumed by preferably all the piezo-actuators, for the control unit (120) by multiplying the currently determined energy consumption ($\Delta\overline{\mathbf{W}}_{cur}$) by a correction factor C.

20. Device (100) according to one of Claims 17 or 19, **characterized in that** the control unit (120) has a power-limiting device (129) for limiting the average power consumed by all the piezo-actuators (130-1...130-n$_{cyl}$) in response to the control signal.

21. Device according to Claim 20, **characterized in that** the power-limiting device (129) is designed to limit the power consumed by the piezo-actuators by virtue of the fact that it reduces the actuator voltage, limits the rotational speed (n) of the internal combustion engine, entirely switches off individual piezo-actuators and therefore cylinders and/or omits secondary injections during individual injection cycles.

22. Device according to one of Claims 17-21, **characterized in that** the control device (140) has an energy diagnostic device (149) for generating a fault status message (F) for a piezo-actuator if the energy which is taken up or output by this piezo-actuator, the energy consumption thereof, or the deviation factor (f$_i$) exceeds or undershoots predefined threshold values.

**Revendications**

1. Procédé de conduite d'un moteur à combustion interne qui présente plusieurs (n$_{zyl}$) cylindres commandés par un appareil de commande (120), chacun par l'intermédiaire d'un piézoactionneur (130-1 ... 130-n$_{zyl}$) qui leur est associé individuellement,
**caractérisé par** les étapes qui consistent à :

a. saisir la puissance électrique moyenne ($\overline{\boldsymbol{P}}$) consommée globalement de préférence par tous les piézoactionneurs du moteur à combustion interne (étape S1 du procédé),
b. comparer cette puissance électrique moyenne ainsi saisie à une puissance de consigne ($\overline{\boldsymbol{P}}_{soll}$) prédéterminée qui représente la puissance nominale qui peut être délivrée par l'appareil de commande aux piézoactionneurs (étape S2 du procédé) et

c. réduire la puissance électrique future consommée globalement par les piézoactionneurs (130-1 ... 130-n$_{zyl}$) lorsque la comparaison montre que la puissance électrique moyenne saisie est supérieure à la puissance de consigne $(\overline{P}_{soll})$ prédéterminée (étape S3 du procédé),

la saisie de la puissance électrique moyenne $(\overline{P})$ consommée de préférence par tous les piézoactionneurs (N$_A$ = n$_{zyl}$) comportant les étapes partielles suivantes qui consistent à :

d. saisir la consommation en énergie ($\Delta W_i$) d'un piézoactionneur particulier pour une injection particulière en tant que différence entre l'énergie (W$_{Li}$) absorbée pendant une opération de charge (L) en vue de l'injection et l'énergie (W$_{Ei}$) délivrée par le piézoactionneur pendant une opération ultérieure de décharge (E).

2. Procédé selon la revendication 1, **caractérisé en ce que** la saisie de la puissance électrique moyenne $(\overline{P})$ consommée de préférence par tous les piézoactionneurs (N$_A$ = n$_{zyl}$) comporte les autres étapes partielles suivantes :

a. déterminer une consommation moyenne en énergie $(\Delta \overline{W})$ pour chaque piézoactionneur (130-1 ... 130-n$_{zyl}$) en additionnant les consommations en énergie de préférence de tous les piézoactionneurs et en divisant la somme par le nombre des piézoactionneurs (N$_A$ = n$_{zyl}$) et

b. convertir la consommation moyenne en énergie $\Delta \overline{W}$ des piézoactionneurs en la puissance moyenne $(\overline{P})$ consommée de préférence par tous les piézoactionneurs.

3. Procédé selon la revendication 1, **caractérisé en ce que** la saisie de la puissance électrique moyenne $(\overline{P})$ consommée de préférence par tous les piézoactionneurs (N$_A$ = n$_{zyl}$) comporte les autres étapes partielles suivantes :

a. déterminer un facteur d'écart (f$_i$) en divisant la consommation en énergie ($\Delta W_i$) spécifique à un cylindre par une consommation nominale en énergie ($\Delta W_{nom}$) de chaque piézoactionneur ou de chaque cylindre,

b. pour chaque piézoactionneur, calculer un facteur d'écart moyen $(\overline{f})$ de tous les piézoactionneurs en additionnant les facteurs d'écart de préférence de tous les piézoactionneurs et en divisant cette somme par le nombre de préférence de tous les cylindres ou de tous les piézoactionneurs,

c. calculer la moyenne temporelle du facteur d'écart moyen de tous les piézoactionneurs et calculer la consommation effective en énergie $(\Delta \overline{W}_{akt})$ déterminée pour chaque piézoactionneur en multipliant le facteur d'écart moyen $(\overline{f}_t)$ de tous les piézoactionneurs par la consommation nominale en énergie ($\Delta W_{nom}$) et

d. convertir la consommation en énergie effective $(\Delta \overline{W}_{akt})$ ainsi déterminée en la puissance moyenne $(\overline{P})$ consommée de préférence par tous les piézoactionneurs.

4. Procédé selon les revendications 2 ou 3, **caractérisé en ce que** la consommation en énergie ($\Delta W_i$) d'un piézoactionneur (130-1 ... 130-n$_{zyl}$) particulier est calculée à partir de l'évolution de la tension (U$_{Mess}$) à ses bornes et la modification de sa charge (Q$_i$).

5. Procédé selon les revendications 2, 3 ou 4, **caractérisé en ce que** la conversion de la consommation moyenne effective en énergie $(\Delta \overline{W}_{akt})$ en la puissance moyenne $(\overline{P})$ consommée de préférence par tous les piézoactionneurs s'effectue en appliquant les équations (5), (6) ci-dessous :

$$\overline{P} \;=\; \overline{\Delta W_{akt}} \;.\, C, \qquad\qquad (5)$$

avec

$$C \;=\; n.n_{zyl}.n_{inj}/(2.60)\,[Einspritzzyklen/s], \qquad\qquad (6)$$

dans lesquelles

$\overline{P}$ représente la puissance électrique moyenne consommée par les piézoactionneurs,

$\overline{W}_{akt}$ représente la consommation moyenne effective en énergie de chaque piézoactionneur du moteur à combustion interne pour chaque injection,

C représente un facteur de correction,

n représente le régime de rotation du moteur à combustion interne,

$n_{zyl}$ représente le nombre des cylindres ou le nombre des piézoactionneurs du moteur à combustion interne,

$n_{inj}$ représente le nombre d'injections par cycle d'injection,

2 représente un facteur qui tient compte du fait que dans le moteur à combustion interne, une injection n'a lieu que pour deux rotations du vilebrequin et

60 représente le facteur de conversion des minutes en secondes.

6. Procédé selon l'une des revendications précédentes, **caractérisé en ce que** la puissance de consigne $\overline{P}$ prédéterminée par l'appareil de commande correspond à la puissance nominale délivrée par l'appareil de commande (120) ou par un dispositif (122) de conversion courant continu-courant continu.

7. Procédé selon l'une des revendications 1 à 6, **caractérisé en ce que** la puissance de consigne prédéterminée $\overline{P}_{soll}$ de l'appareil de commande correspond à la puissance du dispositif de conversion (122) mesurée lors du démarrage de l'appareil de commande.

8. Procédé selon l'une des revendications précédentes, **caractérisé en ce que** la puissance électrique moyenne consommée par les piézoactionneurs (130-1 ... 130-$n_{zyl}$) est réduite en diminuant la fréquence d'activation d'un des piézoactionneurs par suppression des injections à priorité plus basse.

9. Procédé selon l'une des revendications précédentes, **caractérisé en ce que** la puissance électrique moyenne consommée par les piézoactionneurs est réduite en débranchant au moins un piézoactionneur et donc simultanément un cylindre.

10. Procédé selon l'une des revendications précédentes, **caractérisé en ce que**, la puissance électrique moyenne consommée par les piézoactionneurs est réduite en limitant le régime de rotation (n) du moteur à combustion interne.

11. Procédé selon l'une des revendications précédentes, **caractérisé en ce que** la puissance électrique moyenne consommée par les piézoactionneurs est réduite en réduisant la tension d'actionneur qui commande au moins l'un des piézoactionneurs (130-1 ... 130-$n_{zyl}$).

12. Procédé selon l'une des revendications 2 à 11, **caractérisé en ce qu'**il délivre un message d'état de défaut spécifique à un cylindre si

l'énergie ($W_{Li}$) absorbée par l'un des piézoactionneurs (130-1 ... 130-$n_{zyl}$) pendant une opération de charge dépasse une première valeur de seuil ($\overline{W}_{max}$) prédéterminée ou n'atteint pas une deuxième valeur de seuil ($\overline{W}_{min}$) prédéterminée,

l'énergie ($W_{Ei}$) délivrée par le piézoactionneur pendant une opération de décharge dépasse une troisième valeur de seuil ($\overline{W}_{Emax}$) ou n'atteint pas une quatrième valeur de seuil ($\overline{W}_{Emin}$) et/ou

la consommation en énergie ($\Delta W_i$) d'un piézoactionneur lors de chaque injection dépasse une cinquième valeur de seuil ($\Delta\overline{W}_{min}$) prédéterminée ou n'atteint pas une sixième valeur de seuil ($\Delta\overline{W}_{min}$).

13. Procédé selon l'une des revendications 4 à 12, **caractérisé en ce que** sur les grandeurs électriques saisies en vue du calcul de la consommation en énergie, par exemple la tension, le courant ou la charge, il effectue une vérification de plausibilité par laquelle les grandeurs électriques saisies ne sont utilisées pour le calcul de la consommation en énergie que si elles sont situées à l'intérieur de plages particulières de valeurs prédéterminées par des valeurs de seuil appropriées.

14. Procédé selon la revendication 13, **caractérisé en ce que** les grandeurs électriques saisies sont corrigées avant d'être utilisées pour le calcul de la consommation en énergie s'il est constaté que les grandeurs électriques sont défectueuses du fait d'un défaut du dispositif de mesure qui les saisit.

15. Programme informatique doté d'un code de programme permettant de commander un moteur à combustion interne, **caractérisé en ce que** le code de programme est configuré pour mettre en oeuvre le procédé selon l'une des revendications 1 à 14.

16. Support de données présentant un programme informatique selon la revendication 15.

17. Ensemble (100) de conduite d'un moteur à combustion interne qui présente plusieurs cylindres ($n_{zyl}$) qui sont tous commandés par des piézoactionneurs (130-1 ... 130-$n_{zyl}$) respectifs, l'ensemble comportant :

un appareil de commande (120) qui commande individuellement les piézoactionneurs (130-1 ... 130-n$_{zyl}$),
**caractérisé par**
un dispositif de régulation (140) qui saisit la puissance électrique moyenne ($\overline{P}$) consommée de préférence par tous les piézoactionneurs du moteur à combustion interne et qui délivre pour l'appareil de commande (120) un signal de commande qui représente une indication délivrée à l'appareil de commande (120) à réduire la puissance électrique consommée par les piézoactionneurs (130-1 ... 130-n$_{zyl}$) lorsqu'il est constaté que la puissance électrique ($\overline{P}$) saisie dépasse une valeur de consigne ($\overline{P}_{soll}$) prédéterminée qui représente la puissance nominale que l'appareil de commande (120) peut délivrer aux piézoactionneurs, le dispositif de régulation (140) présentant :

un dispositif (141) de mesure de charge qui saisit les charges (Q$_l$) associées individuellement aux différents piézoactionneurs (130-1 ... 130-n$_{zyl}$) ou aux cylindres,
un dispositif (142) de mesure d'énergie qui calcule l'énergie (W$_{Li}$) absorbée par un piézoactionneur (130-1 ... 130-n$_{zyl}$) pendant une opération de charge pour une injection particulière et l'énergie (W$_{Ei}$) délivrée par le même piézoactionneur pendant une opération de décharge (E) et
un dispositif de soustraction (143) qui calcule la consommation en énergie (ΔW$_i$) spécifique aux cylindres en tant que différence entre l'énergie absorbée et l'énergie délivrée.

**18.** Ensemble (100) selon la revendication 17, **caractérisé en ce que** le dispositif de régulation (140) présente :

un dispositif (144) de formation de valeurs moyennes qui détermine pour chaque piézoactionneur la consommation moyenne en énergie ($\Delta\overline{W}$) par rapport à tous les piézoactionneurs,
un filtre temporel (145) qui assure un filtrage temporel et en particulier qui assure le calcul de la moyenne de la consommation moyenne en énergie des piézoactionneurs pour former une consommation moyenne effective en énergie ($\overline{\Delta W}_{akt}$) et
un dispositif multiplicateur (146) qui calcule la puissance moyenne (P) de préférence de tous les piézoactionneurs en multipliant la consommation en énergie ($\overline{\Delta W}_{akt}$) par un facteur de correction C.

**19.** Ensemble (100) selon la revendication 17, **caractérisé en ce que** le dispositif de régulation (140) présente :

une variante (142') de dispositif de mesure
d'énergie qui calcule la consommation nominale en énergie (ΔW$_{nom}$) d'un piézoactionneur,
un dispositif de normalisation (143') qui normalise la consommation en énergie (ΔW$_i$) spécifique à un cylindre par rapport à la consommation nominale en énergie (ΔW$_{nom}$), pour fournir un facteur d'écart (f$_i$),
une variante (144') de dispositif de formation de moyenne qui détermine un facteur d'écart moyen ($\overline{f}$) de préférence sur tous les cylindres ou sur tous les piézoactionneurs,
une variante (145') de filtre temporel qui assure le calcul de la moyenne temporelle du facteur d'écart moyen ($\overline{f}$) de préférence sur tous les piézoactionneurs et qui calcule une consommation effective en énergie ($\overline{\Delta W}_{akt}$) pour chaque piézoactionneur en multipliant la moyenne temporelle du facteur d'écart ($\overline{f_t}$) par la consommation nominale en énergie (ΔW$_{nom}$) et
un dispositif multiplicateur (146) qui calcule pour l'appareil de commande (120) le signal de commande qui représente la puissance électrique (P) consommée de préférence par tous les piézoactionneurs en multipliant la consommation effective en énergie ($\overline{\Delta W}_{akt}$) par un facteur de correction C.

**20.** Ensemble (100) selon l'une des revendications 17 ou 19, **caractérisé en ce que** l'appareil de commande (120) présente un dispositif (129) de limitation de puissance qui limite la puissance moyenne consommée globalement par les piézoactionneurs (130-1 ... 130-n$_{zyl}$) en réponse au signal de commande.

**21.** Ensemble selon la revendication 20, **caractérisé en ce que** le dispositif (129) de limitation de puissance est configuré pour limiter la puissance consommée par les piézoactionneurs en réduisant la tension appliquée aux actionneurs, en limitant le régime de rotation (n)
du moteur à combustion interne, en débranchant complètement certains piézoactionneurs et donc certains cylindres et/ou en supprimant des injections secondaires de certains cycles d'injection.

**22.** Ensemble selon l'une des revendications 17 à 21, **caractérisé en ce que** le dispositif de régulation (140) présente un dispositif (149) de diagnostic d'énergie qui produit un message (F) d'état de défaut d'un piézoactionneur si l'énergie absorbée ou délivrée par ce piézoactionneur, l'énergie qu'il consomme ou le facteur d'écart (f$_i$) dépassent ou n'atteignent pas des valeurs de seuil prédéterminées.

Fig. 1

EP 1 519 025 B1

## Fig. 2

$$\overline{P} > \overline{P}_{soll}$$

# Fig. 3

# Fig. 4

EP 1 519 025 B1

**Fig. 5**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1139444 A1